# EUROPEAN PATENT APPLICATION

(11) **EP 4 576 175 A1**
(43) Date of publication of application: **25.06.2025**
(21) Application number: 23219615.4
(22) Date of filing: 22.12.2023
(51) Int. Cl.: H01L 21/48, H01L 23/498

(54) **A METHOD FOR FORMING TERMINAL PIN CONNECTIONS OF A SEMICONDUCTOR MODULE AND A SEMICONDUCTOR MODULE WITH TERMINAL PIN CONNECTIONS**

(71) Applicant: Infineon Technologies AG, 85579 Neubiberg (DE)
(72) Inventor: MEIS, Lukas, 33142 Büren (DE); NOTTELMANN, Regina, 59510 Lippetal, Hovestadt (DE); DREPS, Florian, 33106 Paderborn (DE)
(74) Representative: Infineon Patent Department

(57) **Abstract**

A method for producing a semiconductor module comprising, providing a substrate comprising a metal layer with a surface and mounting a first metal sheet on the surface of the metal layer, wherein a lateral extension of the first metal sheet along the surface of the metal layer exceeds a thickness of the first metal sheet measured in a direction orthogonal to the surface of the metal layer. The method further comprises inserting a terminal pin into a first side of the first metal sheet, wherein the first side of the first metal sheet faces away from the first surface of the metal layer and arranging the metal layer, the first metal sheet and the terminal pin in a housing of the semiconductor module, wherein the terminal pin protrudes from the housing to provide an external electrical connection of the semiconductor module.

## Description

### TECHNICAL FIELD

The present disclosure relates to a method for forming terminal pin connections of a semiconductor module and a semiconductor module comprising such a terminal pin connection.

### BACKGROUND

Semiconductor modules are used in a wide range of power electronic applications, e.g. the electrification of electric vehicles, solar cells and wind turbines as inverters, converters, rectifiers, motor control, etc. The semiconductor modules often include a substrate and a semiconductor die inside a housing. The substrate includes a metal layer disposed on a surface of the substrate. The semiconductor die along with other elements such as passive components, bond wires and terminal pins etc. is mounted on the metal layer of the substrate. The terminal pins protrude out from the housing and are used to connect the semiconductor modules to outside of the housing, e.g. external printed circuit board, bus bars or other conductors.

In order to fix the terminal pins onto the substrate sleeves may be mounted on the metal layer of the substrate and then the terminal pin is inserted into the sleeve providing a press fit connection. The sleeve mounting process, e.g. welding, soldering, sintering requires stringent positional tolerances due to small dimensions of the sleeve and hence increases the complexity of manufacturing process of the semiconductor module.

There is thus the need to provide a method for forming a semiconductor module and a semiconductor module that allows connecting the terminal pins with the substrate in a robust, efficient and cost-effective manner.

### SUMMARY

According to an example of the disclosure, a method for forming a semiconductor module comprises providing a substrate comprising a metal layer with a first surface, mounting a first metal sheet on the first surface of the metal layer, wherein a lateral extension of the first metal sheet along the first surface of the metal layer exceeds a thickness of the first metal sheet measured in a direction vertical to the first surface of the metal layer, inserting a terminal pin into a first side of the first metal sheet, wherein the first side of the first metal sheet faces away from the first surface of the metal layer, arranging the metal layer, the first metal sheet and the terminal pin in a housing of the semiconductor module, wherein the terminal pin protrudes from the housing to provide an external electrical connection of the semiconductor module.

According to an example of the disclosure, a semiconductor module comprises a substrate comprising a metal layer with a first surface and a semiconductor die mounted on the surface of the metal layer. A first metal sheet is mounted on the first surface of the metal layer, wherein a lateral extension of the first metal sheet along the first surface of the metal layer exceeds a thickness of the first metal sheet measured in a direction vertical to the first surface of the first metal layer. A term inal pin is inserted into a first side of the metal sheet and electrically connected to the semiconductor die, wherein the first side of the first metal sheet faces away from the first surface of the metal layer. A housing accommodates the semiconductor die, the metal layer, the first metal sheet and the terminal pin, wherein the terminal pin protrudes from the housing to provide an external electrical connection to the semiconductor module.

Those skilled in the art will recognize additional features and advantages upon reading the following detailed description, and upon viewing the accompanying drawings.

### BRIEF DESCRIPTION OF THE DRAWINGS

The present disclosure is illustrated by way of example, and not by way of limitation, in the figures of the accompanying drawings in which like reference numerals refer to similar or identical elements. The elements of the drawings are not necessarily to scale relative to each other. The features of the various illustrated examples can be combined unless they exclude each other.
Figure 1A-1E illustrate an example of a method for forming a semiconductor module using a metal sheet for terminal pin insertion.
Figure 2 illustrates an alternative terminal pin inserted into a substrate.
Figure 3A-3C illustrate an example of a method for mounting terminal pins on a substrate using a stack of metal sheets for terminal pin insertion.
Figure 4A-4D illustrate an alternative example of a method for mounting terminal pins on a substrate using a metal sheet with a hole for terminal pin insertion.
Figure 5A-5C illustrate an alternative example of a method for mounting terminal pins on a substrate using a stack of metal sheets with a hole for terminal pin insertion.
Figure 6 illustrate a cross-sectional view of an example of a semiconductor module with a metal sheet for terminal pin insertion.
Figure 7 illustrate a cross-sectional view of an alternative example of a semiconductor module with a stack of metal sheets for terminal pin insertion.

### DETAILED DESCRIPTION

In the following description, directional terminology, such as "top", "bottom", "upper", "lower" etc., is used with reference to the orientation of figures being described. The components of the disclosure can be positioned in a number of different orientations, the directional terminology is used for purposes of illustration and is in no way limiting.

Furthermore, to the extent that the terms "include", "have", "with" or other variants thereof are used in either the detailed description or the claims, such terms are intended to be inclusive in a manner similar to the term "comprise". The terms "coupled" and "connected", along with derivatives thereof may be used. It should be understood that these terms may be used to indicate that two elements co-operate or interact with each other regardless of whether they are in direct physical or electrical contact, or they are not in direct contact with each other; intervening elements or layers may be provided between the "bonded", "attached", or "connected" elements.

Although specific examples have been illustrated and described herein, it will be appreciated by those of ordinary skill in the art that a variety of alternate and/or equivalent implementations may be substituted for the specific examples shown and described without departing from the scope of the present invention. This application is intended to cover any adaptations or variations of the specific examples discussed herein. Therefore, it is intended that this invention be limited only by the claims and the equivalents thereof.

It should be noted that the methods and devices including its preferred embodiments as outlined in the present document may be used stand-alone or in combination with the other methods and devices disclosed in this document. In addition, the features outlined in the context of a device are also applicable to a corresponding method, and vice versa. Furthermore, all aspects of the methods and devices outlined in the present document may be arbitrarily combined. In particular, the features of the claims may be combined with one another in an arbitrary manner.

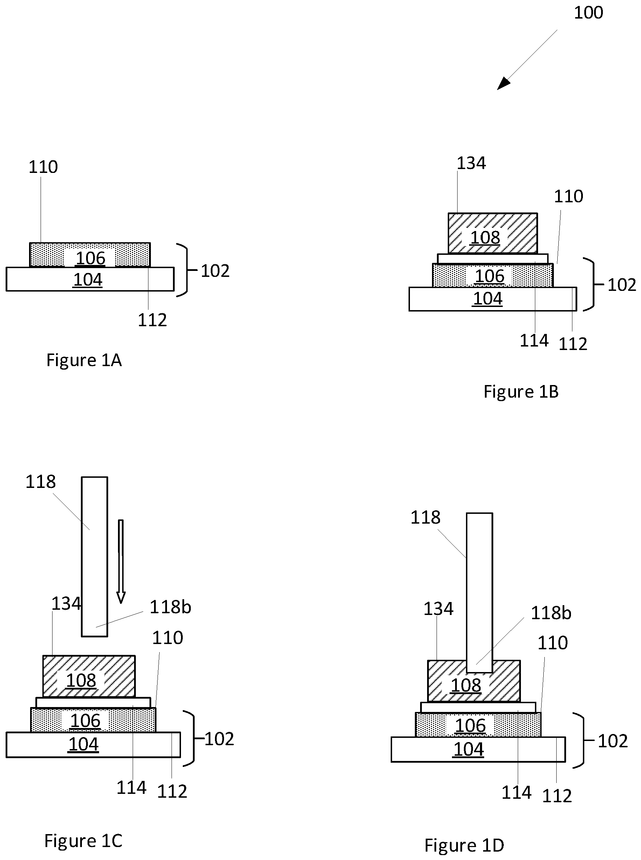

Figures 1A-1E schematically illustrate an example of a method 100 for forming a semiconductor module 150. As shown in Figure 1A, a substrate 102 such as - but not limited to - a direct copper bonding substrate or an active metal brazing substrate, includes a metal layer 106 arranged on a surface 112 of a dielectric sheet 104. The metal layer 106 may be a patterned metal layer meaning that the metal layer 106 is not a continuous layer but includes recesses between different sections of the metal layer 106.

The metal layer 106 has a top surface 110 facing away from the surface 112 of the dielectric sheet 104. The metal layer 106 may be made of but is not limited to, e.g. a copper, a copper alloy, an aluminum, an aluminum alloy and may have a thickness in a range of 0.05 mm to 2.5 mm in the vertical direction.

Referring to Figure 1B, a first metal sheet 108 is mounted on the top surface 110 of the metal layer 106 via an electrically conductive joint 114. The electrically conductive joint 114 electrically and mechanically connects the first metal sheet 108 and the metal layer 106 and may be formed by a solder, or an electrically conductive adhesive, or a sintered metal powder, e.g. a sintered silver (Ag) powder, or welding for example. A lateral extension e_{L} of the first metal sheet 108 parallel to the top surface 110 of the metal layer exceeds a thickness t of the first metal sheet 108 measured orthogonal to the surface 110 of the metal layer. For example, the lateral extension of the first metal sheet 108 may exceed the thickness of the first metal sheet 108 by a factor of 1.5, 2.0, 2.5, 3 or greater than 3. The first metal sheet 108 may be made of similar or different metal as the metal layer 106. The first metal sheet 108 may have a circular or oval or rectangular or square or any other shape and the lateral extension e_{L} of the first metal sheet 108 refers to the lateral extension e_{L} in one lateral direction.

In some examples, the first metal sheet 108 may be printed on the top surface 110 of the metal layer 106 by 3D printing technique.

A terminal pin 118 is inserted into the first metal sheet 108 from a first side 134 of the first metal sheet 108 as shown in Figures 1C-1D. The first side 134 of the first metal sheet 108 faces away from the top surface 110 of the metal layer 106.

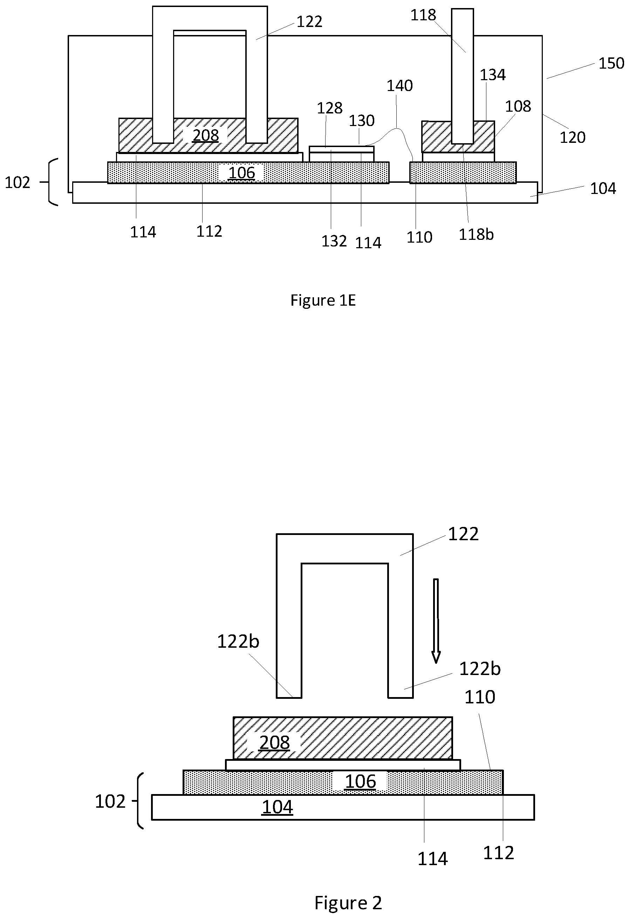

The terminal pin as shown in Figs. 1A-E only has a single leg. However, the terminal pin may also have two or more legs providing at least one redundant path for the electrical current. Such an exemplary terminal pin is shown in Figure 2. The method for inserting a terminal pin 122 with two or more legs is the same as for the terminal pin 118. The terminal pin 122 may be used alternatively or in addition to the terminal pin 118. In particular, the terminal pin 118 may be inserted into the first metal sheet 108 and the terminal pin 122 may be inserted into a second metal sheet 208. The second metal sheet 208 may be mounted on a different section of the metal layer 106, in particular to a separated section of a patterned metal layer. The terminal pin 118 may be used for signal routing while the terminal pin 122 may be used for higher current routing such as but not limited to, e.g. a load current connection of a semiconductor module, or in case of critical functionality, e.g. to provide a redundant signal connection in case of failure of the other terminal pin.

The terminal pins 118, 122 are partially inserted into the respective metal sheets 108, 208. In particular, bottom ends 118b, 122b of the respective terminal pins 118, 122 are pressed into the respective metal sheets 108, 208. The terminal pins 118, 122 can be flexibly inserted into the respective metal sheets 108, 208 without requiring stringent position thresholds which increases the flexibility for mounting terminal pins 118, 122 on the substrate 102. A length of the terminal pins 118, 122 inside the respective metal sheets 108, 208 defines a clamping length of the respective terminal pins 118, 122. The metal sheets 108, 208 increase the clamping length of the respective terminal pins 118, 122 and thus increase the mechanical stability of terminal pins 118, 122 on the substrate 102 by increasing elasticity and resistance against mechanical and vibrational fatigue of the terminal pins 118, 122 during operation of the semiconductor module. The clamping length of the terminal pins 118, 122 may be increased by increasing the thickness of the respective metal sheets 108, 208, thereby further enhancing the mechanical stability of terminal pins 118, 122 on the substrate 102.

After arranging the first metal sheet 108 and/or the second metal sheet 208 on the substrate 102, and inserting the terminal pins 118, 122 into the respective metal sheets 108, 208, the substrate 102 is arranged inside a housing 120 to form the semiconductor module 150 as shown in Figure 1E. The metal layer 106 and the metal sheets 108, 208 are enclosed by the housing 120 while the terminal pins 118, 122 partially protrude from the housing 120 via through holes in the housing 120. A semiconductor die 128 may also be mounted on the top surface 110 of the metal layer 106 via an electrically conductive joint 114 before arranging the substrate 102 inside the housing 130. As exemplary shown in Figure 1E, the electrically conductive joint 114 is arranged between a back side 132 of the semiconductor die 128 and the top surface 110 of the metal layer 106, wherein the electrically conductive joint 114 mechanically and electrically connects the semiconductor die 128 and the metal layer 106. The back side 132 of the semiconductor die 128 is electrically connected with the terminal pin 122 via the second metal sheet 208 and the metal layer 106. A front side 130 of the semiconductor die 128 opposite to the back side 132 is electrically connected with the terminal pin 118 by a bond wire 140 and the first metal sheet 108 and the metal layer 106. Instead of the bond wire 140, a conducting rail or a bond ribbon may also be used.

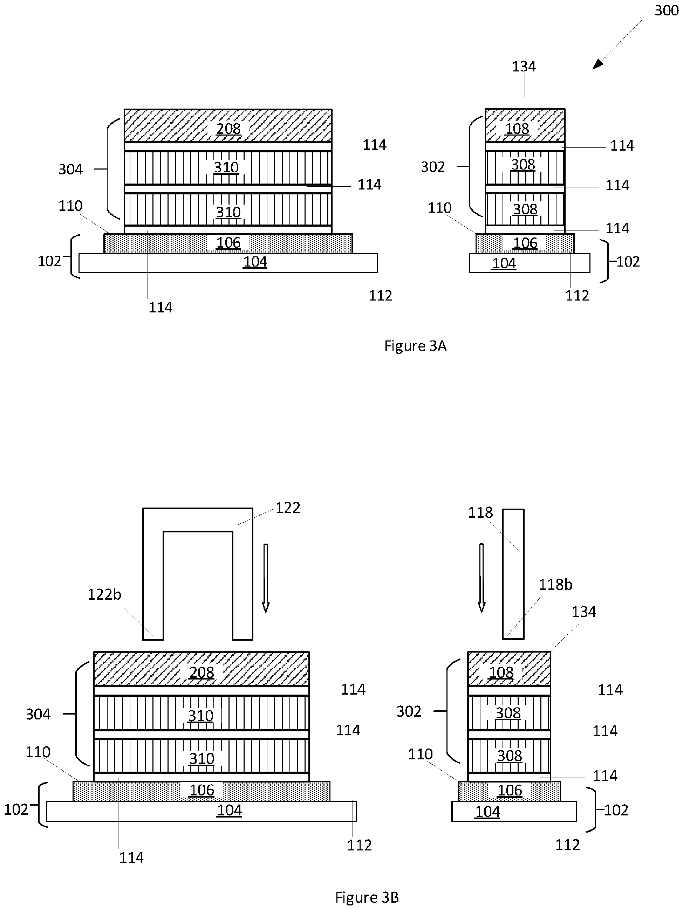

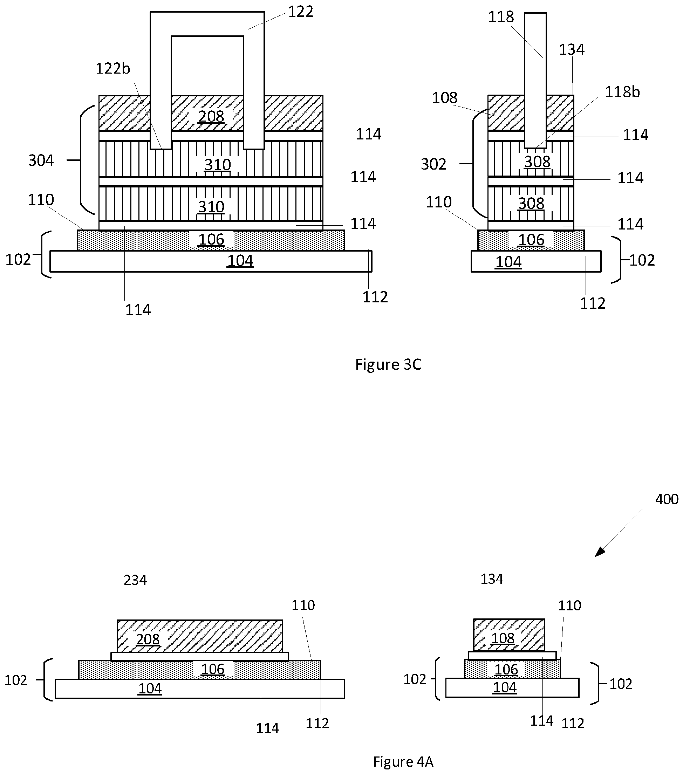

In case of welding the first metal sheet on the substrate, the thickness t is limited due to welding constraints. Instead of using one first metal sheet 108, Two or more metal sheets may be stacked on the metal layer 106 of the substrate 102 and the terminal pins 118, 122 are inserted into the two or more metal sheets. Figures 3A-3C schematically illustrate an example of a method 300 for mounting the terminal pins 118, 122 on the substrate 102 using such a stack of metal sheets. The method 300 may include some or all steps of the method 100 of Figure 1 and will be discussed in regards of the differences only. The method steps shown on the left side and the right side of Figures 3A-3C are illustrate the handling of a one or two leg terminal pin in an analog fashion and will be described simultaneously. Again the method can be used either for one leg terminal pins for two leg terminal pins or for both successively or simultaneously. One or more additional second metal sheets 308, 310 are mounted between the respective metal sheets 108, 208 and the top surface 110 of the metal layer 106. The metal sheets 108, 208 together with one or more second metal sheets 308, 310 form a stack 302, 304 respectively as shown in Figure 3A. The one or more second sheets 308, 310 are mounted on their respective neighboring sheets 108, 208 and the respective metal layer 106 by the electrically conductive joint 114. The metal sheets 108 and 308 as well as 208 and 310 may have the same thickness or different thicknesses.

Referring to the left side and the right side of Figures 3B-3C, the terminal pins 118, 122 are inserted into the respective metal sheets 108, 208 as described in the method 100 of Figures 1A-1E and Figure 2 respectively. The bottom ends 118b,122b of the respective terminal pins 118, 122 may further pass through the respective metal sheets 108, 208 and extend into one or more of the one or more second metal sheets 308, 310 of the respective stacks 302, 304, further increasing the clamping length of the terminal pins 118, 122 and mechanical stability of the terminal pins 118, 122 on the respective substrate 102. The clamping length of the terminal pins 118, 122 may be increased by increasing the number of one or more second sheets 308, 310 in the respective stack 302, 304.

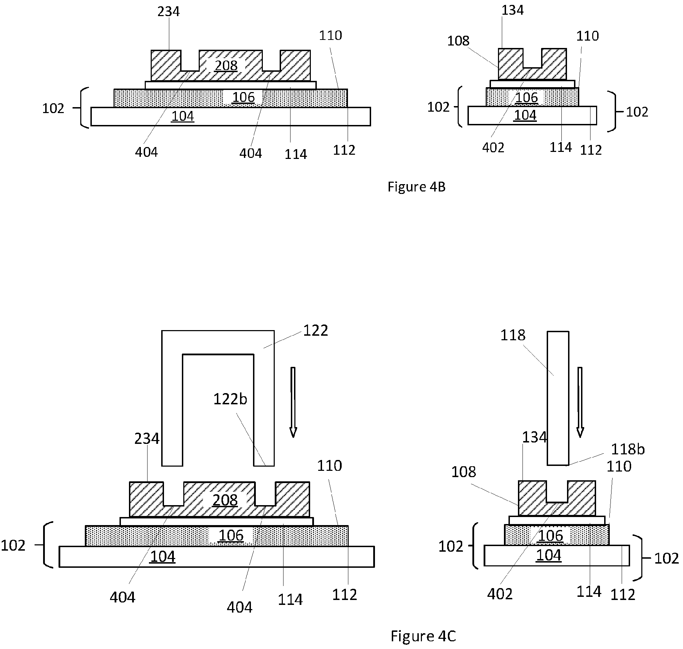

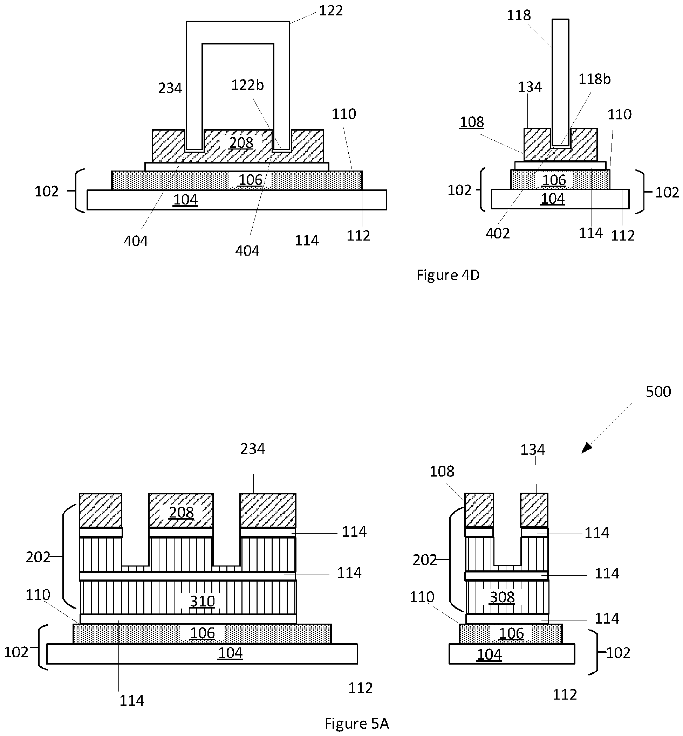

Figures 4A-4D schematically illustrate an alternative example of a method 400 for mounting of the terminal pins 118, 122 on the substrate 102. The method 400 may include some or all steps of the method 100 of Figure 1 and will be discussed in regards of the differences only. Figures on the left side and right side of Figure 3A-3D show handling of one leg terminal pins and two leg terminal pins in analogue fashion and will be described simultaneously. Figures 4A-4B show the substrate 102 after mounting the metal sheets 108, 208. One or more connection holes 402, 404 are formed on the first side 134, 234 of the respective first metal sheet 108,208 by means of, e.g. laser drilling. The depth of the connection holes 402, 404 measured in the vertical direction can be flexibly chosen according to the thickness of the respective metal sheets 108, 208. The holes may even have a depth equal to the thickness of the the respective metal sheets 108, 208.

As shown in the left side and right side of Figures 4C-4D, the bottom ends 118b, 122b of the terminal pins 118, 122 are inserted into the respective connection holes 402, 404, e.g. as a press-fit connection.

In some examples, the metal sheets 108, 208 are provided with the connection holes 402, 404 before mounting the metal sheets 108, 208 on the metal layer 106. This may reduce the stress on the substrate 102 while mounting the terminal pins 118, 122 onto the substrate 102.

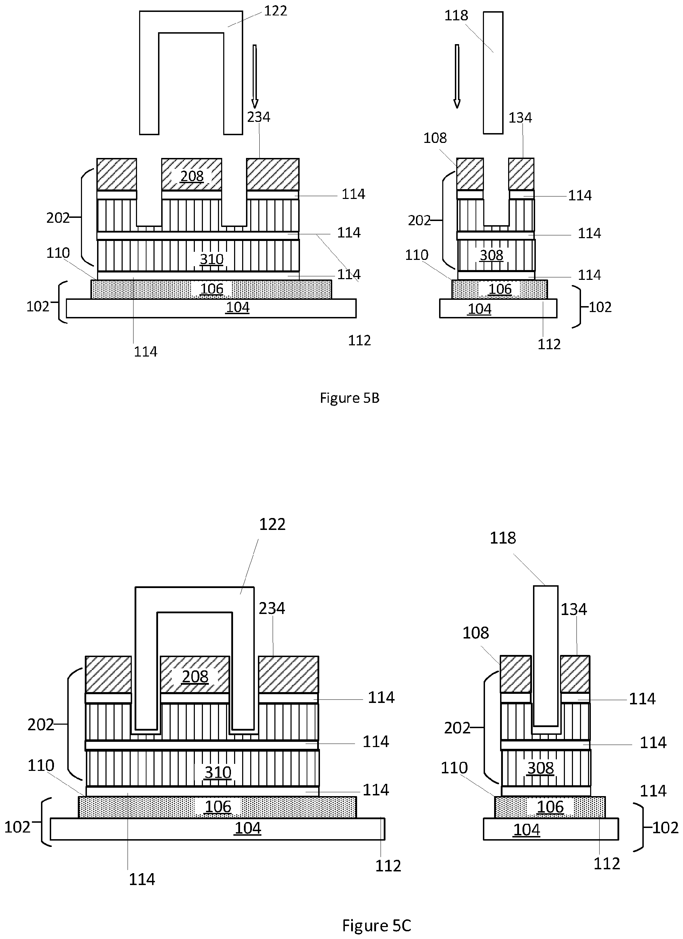

Figures 5A-5C schematically illustrate an example of a method 500 for mounting of the terminal pins 118, 122 on the substrate 102. The method 500 may include some or all steps of the method 300 of Figure 3A-3D as well as the method 400 of Figure 4A-4C and will be discussed in regards of the differences only. Figures on the left side and right side of Figure 5A-5C show handling of one leg terminal pins and two leg terminal pins in analogue fashion and will be described simultaneously. After forming the stacks 302, 304 of the metal sheet 108, 208 and the respective one or more second metal sheets 308, 310, the connection holes 402, 404 are formed on the first sides 134, 234 of the respective metal sheet 108, 208 as shown in Figure 5A. The depth of the connection holes 402, 404 may be larger than the thickness of the respective metal sheets 108, 208, i.e. the connection holes 402, 404 may pass through the respective metal sheets 108, 208 and extend into the respective one or more second metal sheets 308, 310. Referring to the left side and the right side of Figures 5B-5C, after forming the connection holes 402, 404 the terminal pins 118, 122 are inserted into the respective connection holes 402, 404 as described in the Figures 4C-4D of the method 400.

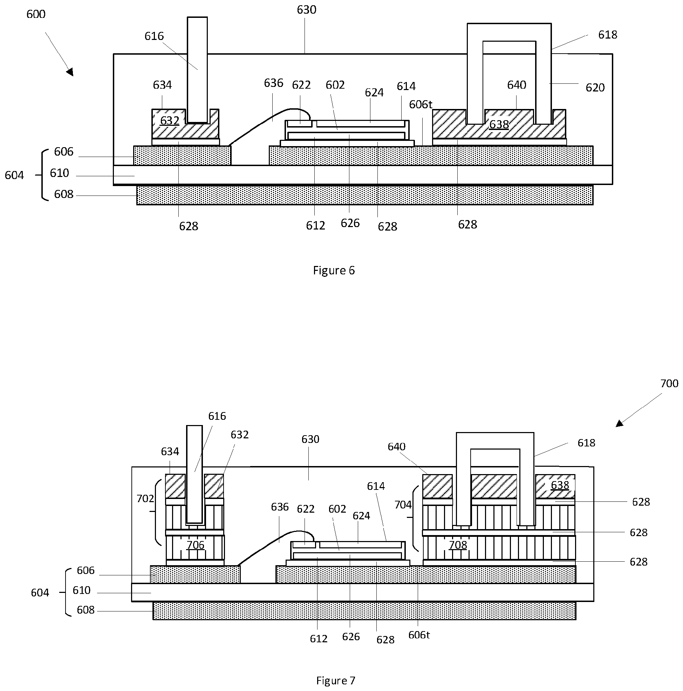

In Figure 6, a cross-sectional view of a semiconductor module 600 is illustrated. The semiconductor module 600 has a semiconductor die 602 mounted on a substrate 604. The semiconductor module 600 may be configured as, e.g. a half-bridge circuit. The substrate 604 has a top metal layer 606 and a bottom metal layer 608 disposed on opposing sides of a dielectric sheet 610. The top metal layer 606 is a patterned layer and used for routing electric current in the semiconductor module 600. The bottom metal layer 608 is optional and may be a plain sheet of a metal having a uniform thickness or may have non-uniform thickness forming cooling structures like pin fins etc.. The top 606 and bottom 608 metal layers may comprise, e.g. but not limited copper, copper alloy, aluminum, and aluminum alloy and have thickness in a range of 0.05 mm to 2.5 mm in the vertical direction.

The semiconductor die 602 is mounted on a top surface 606t of the top metal layer 606 by an electrically conductive joint 628. The top surface 606t of the top metal layer 606 faces away from the respective side of the dielectric sheet 610. The electrically conductive joint 628 is arranged between a backside 612 of the semiconductor die 602 and the top surface 606t of the top metal layer 606 and connects electrically and mechanically the top metal layer 606 and the semiconductor die 602. The semiconductor die may be a vertical device comprising a first load electrode 626 at the back side 612 and a second load electrode 624 and a control electrode 622 at a front side 614 opposite to the back side 612.

A first metal sheet 632 and a second metal sheet 638 are mounted on different sections of the top surface 606t of the top metal layer 606 by an electrically conductive joint 628. The terminal pins 616, 618 are inserted into a top side 634, 640 of the respective metal sheet 632, 638 and electrically coupled with the semiconductor die 602 via the first metal sheet 632 using one of the methods 100, 300-500 of Figure 1 and Figure 3 to Figure 5 respectively. The terminal pin 616 in this example, is electrically coupled with the control electrode 622 of the semiconductor die 602 via the first metal sheet 632 and the top metal layer 606.The first load electrode 626 of the semiconductor die 602 is electrically coupled with the terminal pin 618 via the second metal sheet 638 and the top metal layer 606. The terminal pin 618 provides redundant electrical contacts to the first load electrode 626 of the semiconductor die 602 to carry a load current.

The semiconductor die 628 and the metal sheets 632, 638 are enclosed inside a housing 630. The bottom metal layer 608 is exposed from the housing 630 for cooling purposes. The terminal pins 616, 618 protrude out from the housing 630 to provide an external electrical connection of the semiconductor module 600.

Figure 7 shows a cross-sectional view of a semiconductor module 700. The semiconductor module 700 may include some or all features of the semiconductor module 600 of Figure 600. The semiconductor module 700 has one or more second metal sheets 706, 708 mounted between the respective metal sheet 632, 638 and the top surface 606t of the top metal layer 606 forming a stack 702 and 704 respectively. The one or more second sheets 706, 708 are connected to their respective neighboring sheets and the metal layer 606 by the electrically conducive layer 628. The terminal pins 616, 618 are inserted into the respective stack 702, 704 and may pass through the respective metal sheets 632, 638 and extend into the respective one or more second metal sheets 706, 708 as described in the method 300 of Figure 3A-3C.

The semiconductor die may, for example, be configured as power MISFETs (Metal Insulator Semiconductor Field Effect Transistors), power MOSFETs (Metal Oxide Semiconductor Field Effect Transistors), IGBTs (Insulated Gate Bipolar Transistors), JFETs (Junction Gate Field Effect Transistors), HEMTs (High Electron Mobility Transistors), power bipolar transistors or power diodes such as, e.g. PIN diodes or Schottky diodes.

The semiconductor die may be manufactured from specific semiconductor material such as, for example, Si, SiC, SiGe, GaAs, GaN, AlGaN, InGaAs, InAlAs, etc., and, furthermore, may contain inorganic and/or organic materials that are not semiconductors. The semiconductor die may be of different types and may be manufactured by different technologies.

The semiconductor module described herein includes a substrate. The substrate may form a part of a structured metal layer such as, e.g. a leadframe. The substrate may include a sheet of ceramics coated with a metal layer, e.g. a metal bonded ceramics substrate. By way of example, the substrate may be a DCB (direct copper bonded) ceramics substrate.

The semiconductor module described herein includes a terminal pin. The terminal pin may be connected to a load electrode or a control electrode of the semiconductor die via a routing structure of the substrate. The terminal pin may be made of any metal or metal alloy, in particular of metals having high electrical conductivity. By way of example, the terminal pin may comprise or may be made of copper or a copper alloy.

The substrate, the semiconductor die may be surrounded by a housing. The housing may comprise any plastic or non-conducting material and may form part of the periphery of the semiconductor module, i.e. may at least partly define the shape of the semiconductor module.

The semiconductor module described herein includes a metal sheet. The metal sheet may comprise a metal with high thermal and electrical conductivity for e.g. copper, aluminum, alloys of copper or alloys of aluminum.

A variety of different types of electronic devices may be configured to use a semiconductor module as described herein. By way of example, an electronic device in accordance with the disclosure may constitute, e.g. an engine control unit (ECU), a power supply, a DC-DC voltage converter, an AC-DC voltage converter, a power amplifier, and many other devices, in particular power devices.

The following examples pertain to further aspects of the disclosure:
Example 1 discloses a method for producing a semiconductor module comprising:
   - providing a substrate comprising a metal layer with a first surface,
   - mounting a first metal sheet on the first surface of the metal layer, wherein a lateral extension of the first metal sheet along the first surface of the metal layer exceeds a thickness of the first metal sheet measured in a direction orthogonal to the first surface of the metal layer,
   - inserting a terminal pin into a first side of the first metal sheet, wherein the first side of the first metal sheet faces away from the first surface of the metal layer,
   - arranging the metal layer, the first metal sheet and the terminal pin in a housing of the semiconductor module,
      wherein the terminal pin protrudes from the housing to provide an external electrical connection of the semiconductor module.
Example 2 discloses the method according to example 1, further comprising mounting one or more second metal sheets between the first surface of the metal layer and the first metal sheet and forming a stack with the first metal sheet.
Example 3 discloses the method according to example 1 or 2, wherein the terminal comprises two legs and wherein inserting the terminal pin into the first side of the first metal sheet comprises inserting a first one of the two legs of the terminal pin into the first side of the first metal sheet and inserting a second one of the two legs into the first side of the first metal sheet.
Example 4 discloses the method according to example 1 or 2, further comprising forming a connection hole on the first side of the first metal sheet and wherein inserting the terminal pin into the first side of the first metal sheet comprises inserting the terminal pin into the connection hole on the first side of the first metal sheet.
Example 5 discloses the method according to example 4, further comprising forming a further connection hole on the first side of the first metal sheet, wherein the terminal pin comprises two legs and, inserting the terminal pin into the first metal sheet comprises inserting a first one of the two legs of the terminal pin into the connection hole and inserting a second one of the two legs into the further connection hole.
Example 6 discloses the method according to example 4-5, wherein forming the connection hole on the first side of the first metal sheet comprises laser drilling the connection hole into the first side of the first metal sheet prior to inserting the terminal pin.
Example 7 discloses the method according to example 4-5, wherein forming the connection hole on the first side of the first metal sheet comprises forming the connection hole on the first side of the first metal sheet before mounting the first metal sheet on the first surface of the metal layer.
Example 8 discloses a semiconductor module comprising:
   - a substrate comprising a metal layer with a first surface,
   - a semiconductor die mounted on the surface of the metal layer,
   - a first metal sheet mounted on the first surface of the metal layer, wherein a lateral extension of the first metal sheet along the first surface of the metal layer exceeds a thickness of the first metal sheet measured in a direction vertical to the first surface of the first metal layer,
   - a terminal pin inserted into a first side of the metal sheet and electrically connected to the semiconductor die, wherein the first side of the first metal sheet faces away from the first surface of the metal layer,
   - a housing accommodating the semiconductor die, the metal layer, the first metal sheet and the terminal pin,
      wherein the terminal pin protrudes from the housing to provide an external electrical connection to the semiconductor module.
Example 9 discloses the semiconductor module according to example 8, further comprises one or more second metal sheets mounted between the first surface of the metal layer and the first metal sheet and forming a stack with the first metal sheet.
Example 10 discloses the semiconductor module according to example 8-9, wherein the terminal pin comprises two or more legs and wherein the two or more legs are inserted into the first side of the metal sheet.

## Claims

1. A method (100, 300, 400, 500) for producing a semiconductor module comprising:
- providing a substrate (102) comprising a metal layer (106) with a first surface (110),
- mounting a first metal sheet (108, 208) on the first surface (110) of the metal layer (106), wherein a lateral extension of the first metal sheet (108, 208) along the first surface (110) of the metal layer (106) exceeds a thickness of the first metal sheet (108, 208) measured in a direction orthogonal to the first surface (110) of the metal layer (106),
- inserting a terminal pin (118, 122) into a first side (134, 234) of the first metal sheet (108, 208), wherein the first side (134, 234) of the first metal sheet (108, 208) faces away from the first surface (110) of the metal layer (106),
- arranging the metal layer (106), the first metal sheet (108, 208) and the terminal pin (118, 122) in a housing (120) of the semiconductor module, wherein the terminal pin (118, 122) protrudes from the housing (120) to provide an external electrical connection of the semiconductor module.

2. The method (300, 500) according to claim 1, further comprising mounting one or more second metal sheets (308, 310) between the first surface (110) of the metal layer (106) and the first metal sheet (108, 208) and forming a stack (302, 304) with the first metal sheet (108, 208).

3. The method (200, 300, 400, 500) according to claim 1 or 2, wherein the terminal pin (122) comprises two legs (124) and wherein inserting the terminal pin (122) into the first side (234) of the first metal sheet (208) comprises inserting a first one of the two legs of the terminal pin (122) into the first side (234) of the first metal sheet (208) and inserting a second one of the two legs into the first side (234) of the first metal sheet (208).

4. The method (400, 500) according to claim 1 or 2, further comprising forming a connection hole (402) on the first side (134) of the first metal sheet (108) and wherein inserting the terminal pin (118) into the first side (134) of the first metal sheet (108) comprises inserting the terminal pin (118) into the connection hole (402) on the first side (134) of the first metal sheet (108).

5. The method (400, 500) according to claims 4, further comprising forming a further connection hole (404) on the first side (234) of the first metal sheet (208), wherein the terminal pin (122) comprises two legs and, inserting the terminal pin (122) into the first metal sheet (208) comprises inserting a first one of the two legs of the terminal pin (122) into the connection hole (404) and inserting a second one of the two legs into the further connection hole (404).

6. The method (400, 500) according to claim 4-5, wherein forming the connection hole (402, 404) on the first side (134,234) of the first metal sheet (108,208) comprises laser drilling the connection hole (402,404) into the first side (134,234) of the first metal sheet (108,208) prior to inserting the terminal pin (118,122).

7. The method (400, 500) according to any of claims 4-5, wherein forming the connection hole (402,404) on the first side (134,234) of the first metal sheet (108,208) comprises forming the connection hole (402, 404) on the first side (134,234) of the first metal sheet (108,208) before mounting the first metal sheet (108,208) on the first surface (110) of the metal layer (106).

8. A semiconductor module (600, 700) comprising:
- a substrate (604) comprising a metal layer (606) with a first surface (606t),
- a semiconductor die (602) mounted on the surface (606t) of the metal layer (606),
- a first metal sheet (632,638) mounted on the first surface (606t) of the metal layer (606), wherein a lateral extension of the first metal sheet (632,638) along the first surface (606t) of the metal layer (606) exceeds a thickness of the first metal sheet (632,638) measured in a direction vertical to the first surface (606t) of the first metal layer (606),
- a terminal pin (616, 618) inserted into a first side (634, 640) of the metal sheet (632, 638) and electrically connected to the semiconductor die (602), wherein the first side (634, 640) of the first metal sheet (632, 638) faces away from the first surface (606t) of the metal layer (606),
- a housing (630) accommodating the semiconductor die (602), the metal layer (606), the first metal sheet (632, 638) and the terminal pin (616, 618), wherein the terminal pin (616, 618) protrudes out from the housing (630) to provide an external electrical connection to the semiconductor module (600).

9. The semiconductor module (700) according to claim 8, further comprises one or more second metal sheets (706, 708) mounted between the first surface (606t) of the metal layer (606) and the first metal sheet (632, 638) and forming a stack (702, 704) with the first metal sheet (632, 638).

10. The semiconductor module (600, 700) according to any of claims 8-9, wherein the terminal pin (618) comprises two or more legs and wherein the two or more legs are inserted into the first side (640) of the metal sheet (632).
